# EUROPEAN PATENT APPLICATION

(11) **EP 3 432 332 A1**
(43) Date of publication of application: **23.01.2019**
(21) Application number: 17766012.3
(22) Date of filing: 06.01.2017
(51) Int. Cl.: H01H 13/64, H01H 13/52

(54) **TRIGGER SWITCH AND ELECTRICAL TOOL USING SAME**

(30) Priority: 15.03.2016 JP 2016051538
(71) Applicant: Omron Corporation, Kyoto-shi, Kyoto 600-8530 (JP)
(72) Inventor: KOYAMA, Taiki, Okayama-shi Okayama 703-8502 (JP); OMORI, Koji, Okayama-shi Okayama 703-8502 (JP); HOZUMI, Akihiro, Okayama-shi Okayama 703-8502 (JP); KOBAYASHI, Minoru, Okayama-shi Okayama 703-8502 (JP)
(74) Representative: Horn Kleimann Waitzhofer Patentanwälte PartG mbB
(86) International application number: PCT/JP2017/000330
(87) International publication number: WO 2017/159004

(57) **Abstract**

A trigger switch (20) includes: a housing (21); a trigger (70) provided outside the housing (21); a plunger (40) that connects the trigger (70) to the housing (21) so as to approach or separate from the housing (21), and includes a slider (50) disposed inside the housing (21); a first printed wiring board (60) that is disposed inside the housing (21) and includes a sliding resistor (61) configured to contact the slider (50) and a control element that configures a control circuit together with the sliding resistor (61); and a second printed wiring board (65) that is disposed inside the housing (21) separately from the first printed wiring board (60) and electrically connected to the first printed wiring board (60), and includes a power element configured to supply electric current based on a signal of the control element.

## Description

### TECHNICAL FIELD

The present invention relates to a trigger switch, for example, a trigger switch used in an electrical tool such as a power driver, and an electrical tool using the trigger switch.

### BACKGROUND ART

A trigger switch is used to turn on/off power supply of the trigger switch or to control a rotation speed of an electrical tool such as a power driver. Such a trigger switch typically includes a power circuit for supplying electric power to a motor incorporated in an electrical tool and a control circuit for switching a rotational speed and a rotational direction of the motor. Patent Document 1, for example discloses a trigger switch used for such an electrical tool.

In the trigger switch according to Patent Document 1, a plurality of control elements forming a control circuit and a power transistor as a power element constituting a power circuit are provided on a single metal printed wiring board (see FIG. 5 of Patent Document 1).

### PRIOR ART DOCUMENT

### PATENT DOCUMENT

Patent Document 1: U.S. Patent Application Publication No. 2006/0009053 A1

### SUMMARY OF THE INVENTION

### PROBLEMS TO BE SOLVED BY THE INVENTION

However, in the trigger switch of Patent Document 1, the control elements may be adversely affected by heat generated by the power element, since the power circuit constituted by the power element generating a large amount of heat and the control circuit constituted by the control elements having low heat resistance are arranged on the same printed wiring board. As a result, the control elements may be destroyed at worst due to a malfunction.

Specifically, since a large current typically flows through a power transistor disposed on a printed wiring board, a large amount of heat is generated by the power transistor. In addition, when the power transistor generates heat, the control elements disposed around the power transistor are affected by the heat generated by the power transistor. In particular, when the temperature around the control elements exceeds heat resistant temperature, the control elements tends to degrade and causes breakdown.

In view of the above problems, an object of the present invention is to provide a trigger switch which is less prone to failure and an electrical tool using the trigger switch.

### MEANS FOR SOLVING THE PROBLEM

To solve the above problem, a trigger switch according to an aspect of the present invention includes:
a housing;
a trigger provided outside the housing;
a plunger that connects the trigger to the housing so as to approach or separate from the housing, and includes a slider disposed inside the housing;
a first printed wiring board that is disposed inside the housing and includes a sliding resistor configured to contact the slider and a control element that configures a control circuit together with the sliding resistor; and
a second printed wiring board that is disposed inside the housing separately from the first printed wiring board and electrically connected to the first printed wiring board, and includes a power element configured to supply electric current based on a signal of the control element.

### EFFECT OF THE INVENTION

According to the trigger switch of the above aspect, since the control element constituting the control circuit and the power element for supplying current to the electrical tool or the like are respectively provided on the separate printed wiring boards , the control element is hardly affected by the heat generated by the power element. As a result, a trigger switch of which a control element is less prone to deterioration and failure can be achieved.

To solve the above problem, an electrical tool according to an aspect of the present invention includes the above-described trigger switch.

According to the electrical tool of the above aspect, the control element constituting the control circuit and the power element for supplying current to the electrical tool or the like are respectively provided on the separate printed wiring boards. With this configuration, the control element to form the control circuit is less likely to be adversely affected by heat generation by the power element. As a result, an electrical tool of which a control element is less prone to deterioration and failure can be achieved.

### BRIEF DESCRIPTION OF THE DRAWINGS

FIG. 1 is a perspective view of a power driver incorporating a trigger switch according to a first embodiment of the present invention.
FIG. 2 is a perspective view showing only the trigger switch of FIG. 1.
FIG. 3 is a perspective view of the trigger switch shown in FIG. 2 excluding a second cover.
FIG. 4 is a sectional perspective view of the trigger switch shown in FIG. 2 taken along X-Z axes (a mating surface of a first cover and the second cover) excluding a return coil spring.
FIG. 5 is an exploded perspective view of FIG. 2.
FIG. 6 is an exploded perspective view as viewed from a viewpoint different from the exploded perspective view of FIG. 5.
FIG. 7 is a partially enlarged perspective view of FIG. 6.
FIG. 8 is a sectional view of the trigger switch shown in FIG. 2 taken along X-Y axes (a plane orthogonal to the mating surface of the first cover and the second cover and crossing a plunger).
FIG. 9 is a sectional view of the trigger switch shown in FIG. 2 taken along Y-Z axes (a plane orthogonal to an extending direction of an operation shaft of the plunger and crossing an operation table of the plunger).
FIG. 10 is a partially enlarged sectional view of a main part of FIG. 8 taken along X-Y axes (the mating surface of the first cover and the second cover).
FIG. 11 is a sectional view of the trigger switch shown in FIG. 2 taken along X-Z axes (the mating surface of the first cover and the second cover) before operation.
FIG. 12 is a sectional view of the trigger switch shown in FIG. 2 taken along X-Z axes (the mating surface of the first cover and the second cover) during the operation.
FIG. 13 is a sectional view of the trigger switch shown in FIG. 2 taken along X-Z axes (the mating surface of the first cover and the second cover) after the operation.
FIG. 14 is a perspective view of a trigger switch according to a second embodiment of the present invention.
FIG. 15 is a perspective view of a trigger switch according to a third embodiment of the present invention.

### MODE FOR CARRYING OUT THE INVENTION

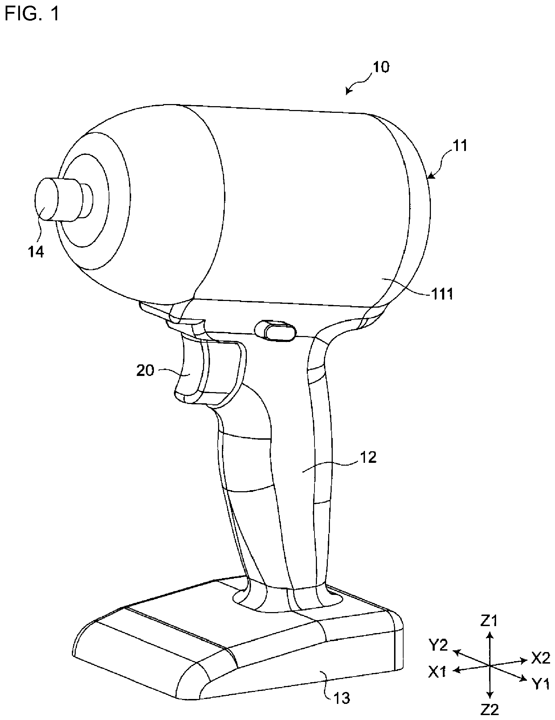

Embodiments of a trigger switch according to the present invention are described below with reference to the accompanying drawings of FIGS. 1 to 15.

In the following description, terms describing directions such as X, Y, Z directions, and other terms indicating other orientations are used in describing the configurations shown in the drawings, and the purpose of using these terms is to facilitate understanding of the embodiments through the drawings. Therefore, the directions indicated by these terms do not necessarily coincide with the actual directions at the time of using the embodiments of the present invention. In addition, these terms should not be interpreted as limiting the technical scope of the invention recited in the claims.

### (First Embodiment)

As shown in FIGS. 1 to 13, a trigger switch 20 according to a first embodiment is fixed to a power driver body 11 of a power driver 10 which is an example of electrical tools, and configures the power driver 10 together with the power driver body 11.

As shown in FIG. 1, the power driver body 11 includes: a drive mechanism housing 111 that houses a drive mechanism (not shown) such as a motor for rotating an anvil 14; a grip 12 extending downward from the drive mechanism housing 111 in a direction substantially orthogonal to the rotation axis of the anvil 14; and a connection base 13 provided at a lower end in an extending direction of the grip 12 and capable of detachably connecting a charging battery (not shown). The trigger switch 20 is provided at a base portion of the grip 12 of the power driver body 11 (an upper end of the grip 12 (an end adjacent the drive mechanism housing 111)). A motor in the drive mechanism housing 111 is electrically connected to the trigger switch 20, and the charging battery is electrically connected to the trigger switch 20.

The trigger switch 20 controls a power circuit (not shown) including a field effect transistor (FET) with a control signal outputted from a control circuit inside the trigger switch 20. The power circuit controls an electric power of the charging battery to be supplied to the motor (not shown) of the power driver 10 to rotate the anvil 14 at a desired rotation speed.

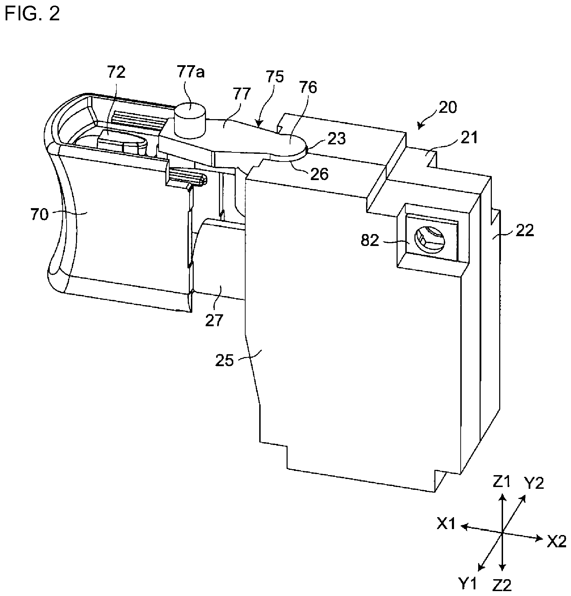

As shown in FIG. 2, the trigger switch 20 according to the first embodiment is configured in a housing 21 with insulation.

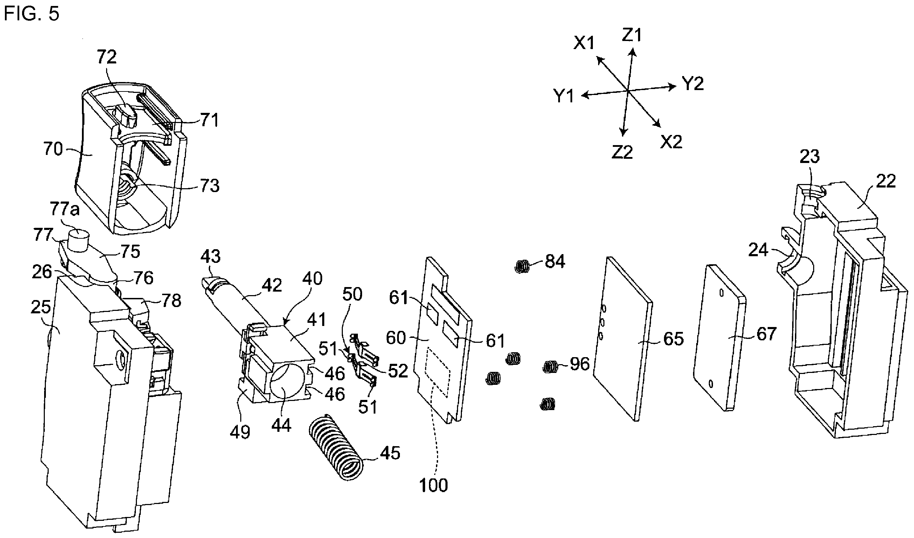

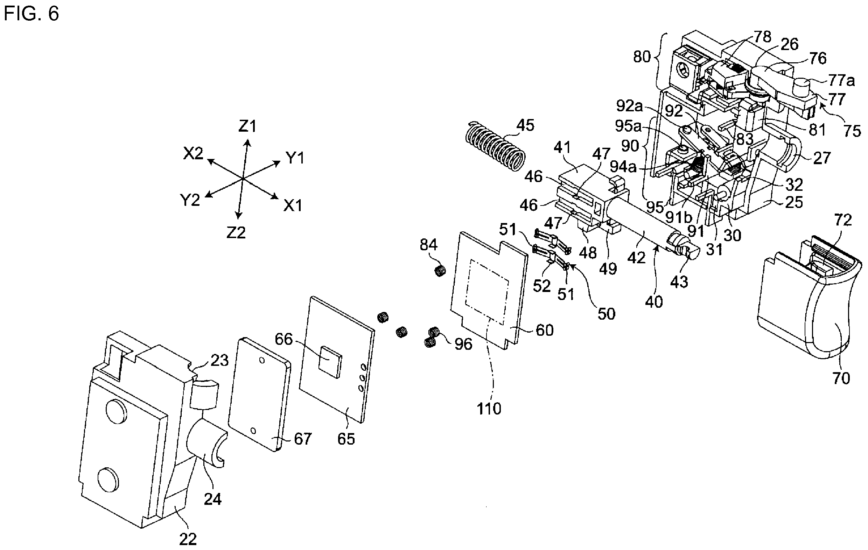

As shown in FIGS. 5 and 6, the trigger switch 20 includes the housing 21 which has a substantially rectangular box shape and is formed of a first cover 22 and a second cover 25, in which internal components such as a base 30, a plunger 40, a first printed wiring board 60, a second printed wiring board 65, and a heat sink 67, a forward/reverse switching mechanism 80, and a contact mechanism 90 are incorporated. Further, a trigger 70 and a switching lever 75 are assembled to the housing 21. The first printed wiring board 60, the second printed wiring board 65, and the heat sink 67 each has a plate shape and are arranged in parallel in a thickness direction. The second printed wiring board 65 is disposed between the first printed wiring board 60 and the heat sink 67.

As shown in FIG. 5, a surface of the first cover 22 in a Z1 direction includes a fitting recess 23 having a semicircular shape at an end thereof in an X1 direction, and the fitting recess 23 supports the switching lever 75 described below. Further, the first cover 22 has a semi-cylindrical rib 24 for supporting an operation shaft 42 of the plunger 40 described below on the surface thereof in the X1 direction (see FIG. 5). In other words, the semi-cylindrical rib 24 is located right under the fitting recess 23.

As shown in FIG. 6, the second cover 25 has a front shape that can be attached to the first cover 22, and a surface of the second cover 25 in the Z1 direction has a fitting recess 26 having a semicircular shape at an end in the X1 direction. The fitting recess 26 supports the switching lever 75 described below. A surface of the second cover 25 in the X1 direction has a semi-cylindrical rib 27 for supporting the operation shaft 42 of the plunger 40.

Note that a joining surface of the second cover 25 excluding an area to which the operation shaft 42 of the plunger 40 and the switching lever 75 described below are attached is integrated with the first cover 22 by using ultrasonic welding or an adhesive. In other words, the first cover 22 and the second cover 25 are integrated with each other by using ultrasonic welding or an adhesive.

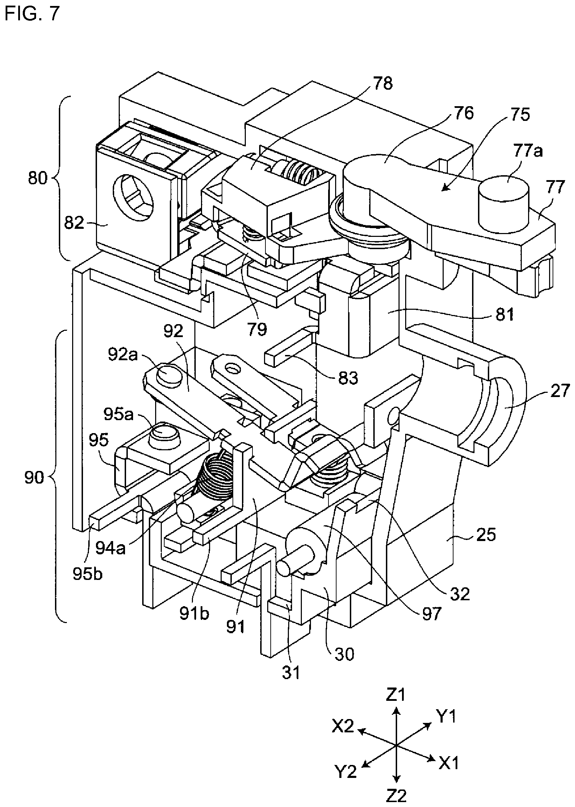

As shown in FIGS. 6 and 7, the base 30 has an outer shape that can be accommodated in the housing 21 and is fixed to the second cover 25. The base 30 has a box shape and has an opening 31 on a surface thereof in a Y2 direction (a surface facing the first cover 22). As shown in FIG. 7, a surface of the base 30 in the X1 direction includes a notch 32 below the semi-cylindrical rib 27. Further, the base 30 is designed so that the forward/reverse switching mechanism 80 (described below) can be held by a surface of the base 30 in the Z1 direction (an upper surface in FIG. 7) and the housing 21. The base 30 is also designed so as to hold the contact mechanism 90 (described below) inside the base 30.

As shown in FIG. 6, the plunger 40 includes an operation table 41 having a rectangular box shape from which the operation shaft 42 projecting in the X1 direction. In other words, the plunger 40 includes the operation table 41 and the operation shaft 42. The operation table 41 is housed inside the housing 21 and is disposed so as to be movable in a contact/separation direction in which the trigger 70 approaches or separates from the housing 21, and includes sliders 50 that have conductivity and extend in the contact/separation direction of the trigger 70 and come into contact with sliding resistors 61 of the first printed wiring board 60 described below. Further, the operation shaft 42 has a substantially cylindrical shape extending in the contact/separation direction of the trigger 70, and has one end in the extending direction connected to the trigger 70 and the other end in the extending direction connected to the operation table 41. The operation shaft 42 includes an engagement rib 43 at a tip end thereof. Referring to FIG. 5, a surface of the operation table 41 in an X2 direction (a surface facing the surface to which the operation shaft 42 is connected) includes a fitting hole 44 that is disposed coaxially with the operation shaft 42. A return coil spring 45 is inserted in the fitting hole 44. Further, as shown in FIG. 6, a surface of the operation table 41 in the Y2 direction (a surface extending in the extending direction of the operation shaft 42) includes two press-fitting grooves 46 that are disposed side by side. Each of the press-fitting grooves 46 extends in parallel with the operation shaft 42, and includes press-fitting notches 47 at the middle thereof. The sliders 50 described below are press-fitted in the press-fitting grooves 46. Further, a surface of the operation table 41 in a Z2 direction (a surface adjacent to the surface that extends in the extending direction of the operation shaft 42 and includes the press-fitting grooves 46 thereon) includes operation units 48, 49 having tapered surfaces in the extending direction of the operation shaft 42.

As shown in FIG. 6, each of the sliders 50 has a rectangular plate shape, and has contact portions 51 at both ends thereof. Each of the contact portions 51 is divided into two parts in a latitudinal direction by a notch provided at the middle in the latitudinal direction. In other words, a contact structure of the trigger switch 20 is a twin-contact structure. Further, each of the sliders 50 includes elastic claw portions 52 at the middle thereof on both edge portions in the latitudinal direction.

Each of the sliders 50 is retained by press-fitting the elastic claw portions 52 thereof into the press-fitting notches 47 included in each of the press-fitting grooves 46 of the plunger 40.

As shown in FIG. 6, the first printed wiring board 60 has a front shape capable of covering the opening 31 of the base 30. The first printed wiring board 60 includes a control element 100 (shown in FIG. 5) mounted thereon such as a resistor and a capacitor in circuit patterns (not shown) printed on front and back surfaces of the first printed wiring board 60. In particular, as shown in FIG. 5, the sliding resistors 61 are print wired on a surface of the first printed wiring board 60 in a Y1 direction. In other words, the first printed wiring board 60 is provided inside the housing 21 and includes the sliding resistors 61 that come into contact with the sliders 50 and the control element 100 constituting the control circuit together with the sliding resistors 61. Note that the control element 100 can be provided at an arbitrary position on the first printed wiring board 60.

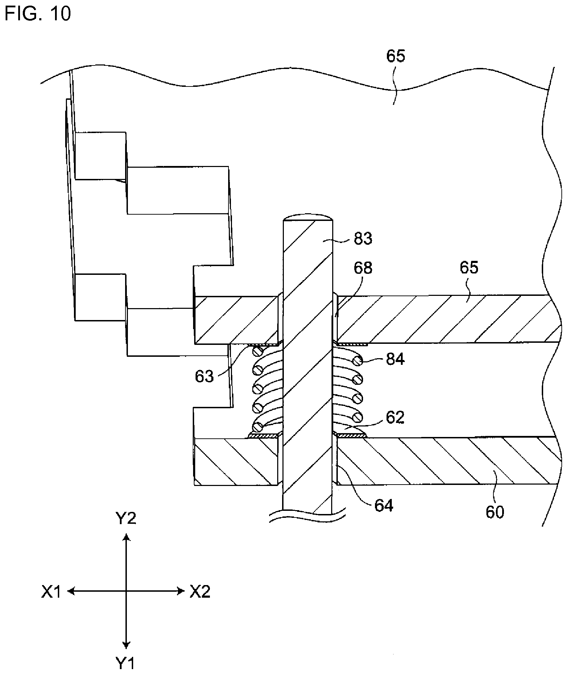

The first printed wiring board 60 includes a first connection hole 64 (an example of a first connection hole shown in FIG. 10), a second connection hole (not shown), and a third connection hole (not shown). The first connection hole 64, the second connection hole, and the third connection hole penetrate the first printed wiring board 60 in the thickness direction. The surface having opening edge portions in the Y2 direction of the first connection hole 64, the second connection hole, and the third connection hole (a surface facing the second printed wiring board 65) includes first wiring patterns 62 printed thereon. Each of first wiring patterns 62 is provided concentrically with a corresponding one of the first connection hole 64, the second connection hole, and the third connection hole. As a result, the first printed wiring board 60 is electrically connected to the second printed wiring board 65 described below through a first coil spring 84, second coil springs 96 described below, a first shaft portion 83, a second shaft portion 91b, and a third shaft portion 95b described below.

As shown in FIG. 6, the second printed wiring board 65 has a front shape capable of covering the opening 31 of the base 30. An outwardly facing surface (that is, a surface facing the heat sink 67) of the second printed wiring board 65 includes a wiring pattern (not shown), and a power element 66 that generates heat is mounted on the wiring pattern. The power element 66 receives a change in a resistance value of each sliding resistor 61 of the first printed wiring board 60 as a control signal, and changes a current value to be supplied to the motor of the power driver 10 according to the change in the received resistance value. The second printed wiring board 65 includes a fourth connection hole 68 shown in FIG. 10 (an example of the second connection hole), a fifth connection hole (not shown), and a sixth connection hole (not shown). The fourth connection hole 68, the fifth connection hole, and the sixth connection hole penetrate the second printed wiring board 65 in the thickness direction. The surface having the opening edge portions in the Y1 direction of the fourth connection hole 68, the fifth connection hole, and the sixth connection hole (a surface facing the first printed wiring board 60) includes second wiring patterns 63 printed thereon. Each of the second wiring patterns 63 is provided concentrically with a corresponding one of the fourth connection hole 68, the fifth connection hole, and the sixth connection hole. As a result, the second printed wiring board 65 is electrically connected to the first printed wiring board 60 through the first coil spring 84, the second coil springs 96 described below, the first shaft portion 83, the second shaft portion 91b, and the third shaft portion 95b described below. Note that the outwardly facing surface of the second printed wiring board 65 refers to a surface closer to the housing 21 among the surfaces facing the housing 21.

As shown in FIG. 6, the heat sink 67 covers and contacts the power element 66. Further, the heat sink 67 is attached to the second printed wiring board 65 by using fixing-metal fittings such as rivets (not shown). The heat sink 67 absorbs heat generated by the power element 66 contacted with the heat sink 67 and dissipates the heat to an outside.

As shown in FIG. 5, the trigger 70 is a molded article that has an angular U-shape in a sectional view along a plane including the X1 and X2 directions and the Y1 and Y2 directions, and includes a reinforcing rib 71 bridged over the opposing inner surfaces thereof (that is, the trigger 70 has a hollow and substantially rectangular box shape, and one side thereof (a side in the X2 direction) is open. The surface of the trigger 70 in the Z1 direction adjacent to the opening side is constituted by the reinforcing rib 71). The upper surface (a surface in the Z1 direction) of the reinforcing rib 71 includes a position regulating projection 72 provided substantially at the center thereof in a protruding manner.

The trigger 70 includes an engagement receiving portion 73 that is projected in the X2 direction on the inner surface of the trigger 70 so as to be integrated with the plunger 40 by engaging the engagement rib 43 provided at the tip end of the operation shaft 42 of the plunger 40 with the engagement receiving portion 73. In other words, the engagement receiving portion 73 that engages with the engagement rib 43 of the operation shaft 42 of the plunger 40 is provided inside the trigger 70. The engagement rib 43 and the engagement receiving portion 73 are engaged with each other, so that the trigger 70 and the plunger 40 are integrated with each other.

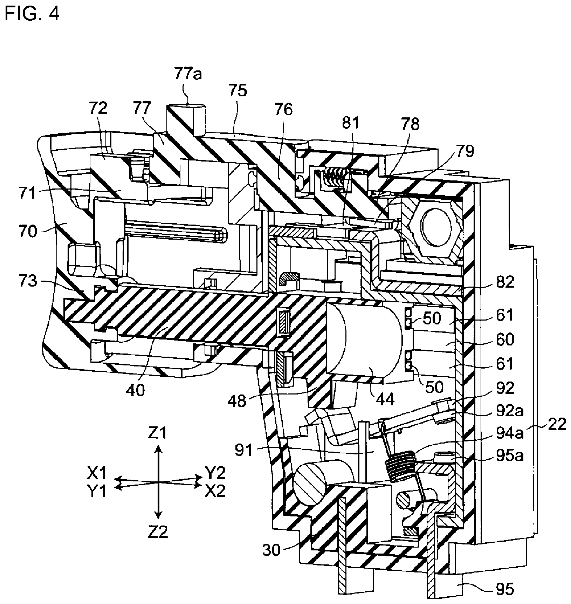

As shown in FIG. 4, the switching lever 75 includes a rotation shaft portion 76 extending in the Z1 direction, an operation unit 77 extending in the X1 direction from the upper end of the rotation shaft portion 76, a switching unit 78 extending in the X2 direction from the lower end of the rotation shaft portion 76. The rotation shaft portion 76 is positioned in and is rotatably supported by the fitting recesses 23, 26 that have a semicircular shape and are respectively provided on the first cover 22 and the second cover 25 (FIG. 2). The operation unit 77 includes an operation projection 77a projecting from the surface of the operation unit 77 in the Z1 direction. A rotating contact piece 79 is provided on the surface in the Z2 direction of the switching unit 78. With this configuration, the rotating contact piece 79 is rotated according to the rotation of the switching lever 75 around the rotation shaft portion 76. Then, the rotating contact piece 79 comes into contact with a first relay terminal 81 of the forward/reverse switching mechanism 80 described below. As a result, electric circuits of the first printed wiring board 60 and the second printed wiring board 65 are switched, so that the rotation direction of the motor (not shown) can be switched between forward and reverse directions.

As shown in FIG. 7, the forward/reverse switching mechanism 80 is configured to switch the circuits by rotating the switching lever 75 around the rotation shaft portion 76. The forward/reverse switching mechanism 80 includes the first relay terminal 81 and an external terminal 82 which have conductivity. The first relay terminal 81 includes the first shaft portion 83 extending in the Y2 direction which is an example of a conductive metal fitting. Referring to FIG. 10, the first shaft portion 83 is inserted in the first connection hole 64 and the fourth connection hole 68 provided respectively in the first printed wiring board 60 and the second printed wiring board 65, and is fixed to one of the first wiring patterns 62 of the first connection hole 64 and one of the second wiring patterns 63 of the fourth connection hole 68 by soldering.

As shown in FIG. 10, the first shaft portion 83 is inserted in the first coil spring 84 disposed between the first printed wiring board 60 and the second printed wiring board 65. Both ends of the first coil spring 84 in an expansion/compression direction are respectively connected to one of the first wiring patterns 62 and one of the second wiring patterns 63, so that the first printed wiring board 60 and the second printed wiring board 65 are electrically connected to each other. Further, the external terminal 82 is exposed to the outside of the housing 21 of the trigger switch 20, and is electrically connected to the motor of the power driver 10 to supply electric power.

As shown in FIG. 7, the contact mechanism 90 is configured to supply electric power to the power driver 10 by turning an opening/closing movable touch piece 92 supported by a movable contact terminal 91. The opening/closing movable touch piece 92 includes an opening/closing movable contact 92a at a free end thereof in the X2 direction, and is rotatably supported by the movable contact terminal 91 through a coil spring 94a.

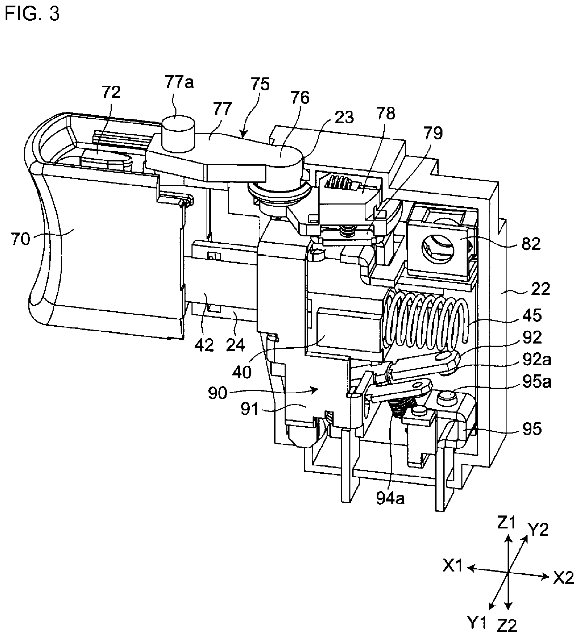

A fixed contact terminal 95 is provided with an opening/closing fixed contact 95a that faces the opening/closing movable contact 92a so as to be able to contact and separate from the opening/closing movable contact 92a (FIG. 3).

As shown in FIG. 7, the second shaft portion 91b which is an example of a conductive metal fitting extends in the Y2 direction from the movable contact terminal 91. A third shaft portion 95b which is an example of the conductive metal fitting extends in the Y2 direction from the fixed contact terminal 95. A member denoted by 97 is a diode.

In summary, the trigger switch 20 includes: the housing 21; the trigger 70 provided outside the housing 21; the plunger 40 that connects the trigger 70 to the housing 21 so as to approach or separate from the housing 21, and includes sliders 50 disposed inside the housing 21; the first printed wiring board 60 that is disposed inside the housing 21 and includes sliding resistors 61 configured to contact the sliders 50 and the control element 100 that configures the control circuit together with the sliding resistors 61; and the second printed wiring board 65 that is disposed inside the housing 21 and is electrically connected to the first printed wiring board 60, and includes the power element configured to supply electric current based on a signal of the control element 100.

A method of assembling the trigger switch 20 made of the above-described component articles is described below.

First, as shown in FIG. 7, the contact mechanism 90 is assembled inside the base 30, and the forward/reverse switching mechanism 80 is assembled to the surface in the Z1 direction of the base 30. At this time, the first relay terminal 81, the movable contact terminal 91, and the fixed contact terminal 95 are assembled to the base 30 such that the first shaft portion 83, the second shaft portion 91b, and the third shaft portion 95b are directed in the Y2 direction.

Then, referring to FIG. 6, the sliders 50 are assembled to the pair of press-fitting grooves 46 provided on the operation table 41 of the plunger 40. At this time, the elastic claw portions 52 of each of the sliders 50 are respectively press-fitted into the press-fitting notches 47 provided on each of the press-fitting grooves 46 so that the sliders 50 are respectively fixed to the press-fitting grooves 46 in a state in which the contact portions 51 at both ends of each of the sliders 50 are projected from the corresponding one of the press-fitting grooves 46. The engagement rib 43 provided at the tip end of the operation shaft 42 of the plunger 40 is engaged with the engagement receiving portion 73 of the trigger 70, so that the plunger 40 and the trigger 70 are integrated with each other.

Then, the plunger 40 is incorporated in the base 30. Specifically, the operation table 41 of the plunger 40 is housed inside the base 30 in a slidable manner in the X1 and X2 directions. At this time, the operation shaft 42 of the plunger 40 is assembled so as to be projected from the semi-cylindrical ribs 24, 27. The plunger 40 is disposed such that one end of the return coil spring 45 contacts the inner surface of the base 30.

Then, the first printed wiring board 60 and the second printed wiring board 65 are assembled to the base 30.

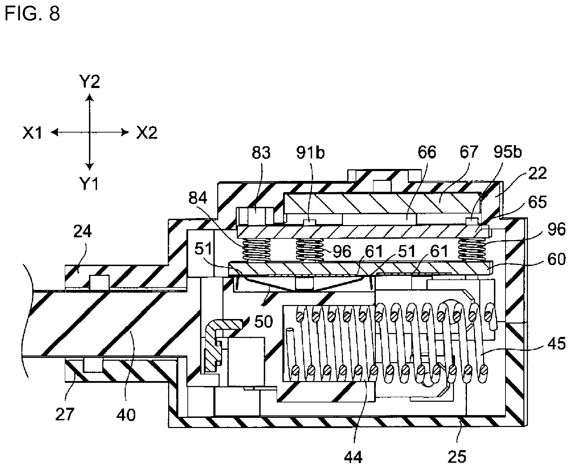

In other words, as shown in FIG. 8, the first shaft portion 83, the second shaft portion 91b, and the third shaft portion 95b are respectively inserted in the first connection hole 64 provided in the first printed wiring board 60 (FIG. 10), the second connection hole, and the third connection hole (not shown). At this time, as shown in FIG. 8, the first printed wiring board 60 is arranged such that the contact portions 51 of each of the sliders 50 assembled to the plunger 40 are in sliding contact with the first printed wiring board 60 and the sliding resistors 61 according to approaching movement and separating movement of the trigger 70.

Next, the first shaft portion 83, the second shaft portion 91b, and the third shaft portion 95b, which are respectively provided on the first relay terminal 81, the movable contact terminal 91, and the fixed contact terminal 95, are inserted in the first coil spring 84 and the second coil springs 96. Then, the first shaft portion 83, the second shaft portion 91b, and the third shaft portion 95b are respectively inserted in the fourth connection hole 68, the fifth connection hole, and the sixth connection hole (not shown) of the second printed wiring board 65, and are fixed by soldering.

At this time, both ends of the first coil spring 84 and both ends of each of the second coil springs 96 in the expansion/compression direction are respectively in contact with the second wiring patterns 63 and the first wiring patterns 62 provided on the opening edge portions of the first connection hole 64, the second connection hole, and the third connection hole.

With this configuration, the first printed wiring board 60 is urged toward the sliders 50 (toward the operation table 41 of the plunger 40) by urging force of the first coil spring 84 and the second coil springs 96 in the Y1 and Y2 directions. Therefore, a contact pressure between the first printed wiring board 60 and each of the sliders 50 is increased. This ensures contact reliability between the sliding resistors 61 of the first printed wiring board 60 and the sliders 50.

Further, the control element 100 and the power element 66 are separately provided on the first printed wiring board 60 and the second printed wiring board 65, respectively. This makes the control element 100 to be less prone to deterioration and failure due to the heat generated by the power element 66. In other words, according to the trigger switch 20, the control element 100 included in the control circuit and the power element for supplying current to the electrical tool or the like are provided in the separate printed wiring boards 60, 65 respectively, and thus the control element 100 is hardly affected by the heat generated by the power element. As a result, a trigger switch of which the control element 100 is less prone to deterioration and failure can be achieved.

The first printed wiring board 60 and the second printed wiring board 65 are arranged so as to face each other with a predetermined gap therebetween in the thickness direction. As a result, a trigger switch of which the control element 100 is hardly affected by the heat generation of the power element and is less prone to deterioration and failure can be achieved.

In general, a wiring pattern constituting a power circuit and a wiring pattern constituting a control circuit are formed to have a uniform thickness. Without enough thickness, the wiring pattern constituting the power circuit may cause a danger, as the wiring pattern for supplying electric power to the motor may be melted by the flowing current.

On the other hand, a large difference in level is generated between the printed wiring board and the sliding resistors in the case where the sliding resistors which are a part of the wiring pattern constituting the control circuit are too thick. Such a large difference in level between the printed wiring board and the sliding resistors causes abrasion of the sliders as the sliders reciprocate between the printed wiring board and the sliding resistors, which may shorten the life of the trigger switch.

Since the trigger switch 20 includes the control element 100 and the power element 66 that are mounted on the separate printed wiring boards, the thickness of the wiring pattern of the first printed wiring board 60 and the thickness of the wiring pattern of the second printed wiring board 65 can be made different from each other. This can reduce abrasion of the contact portions 51 of each of the sliders 50, for example, by reducing the thickness of the sliding resistors 61 of the first printed wiring board 60, thereby achieving a trigger switch having a long life.

On the other hand, for example, the wiring pattern on the second printed wiring board 65 can be made thick to obtain a printed wiring board capable of coping with a large current flowing in the motor of the power driver 10. This configuration prevents the wiring pattern from being melted by the flowing current, thereby providing a safe trigger switch.

Next, the heat sink 67 is disposed on the power element 66 of the second printed wiring board 65, and is fixed to the second printed wiring board 65 with fixing-metal fittings such as rivets (not shown). With this configuration, the heat sink 67 absorbs the heat generated by the power element 66 and dissipates heat to the outside.

Finally, the base 30 is covered with the first cover 22 and the second cover 25 to form the housing 21. At this time, the rotation shaft portion 76 of the switching lever 75 is positioned by the fitting recess 23 of the first cover 22 and the fitting recess 26 of the second cover 25, and the switching lever 75 is rotatably supported by the rotation shaft portion 76 as a fulcrum.

The semi-cylindrical rib 24 of the first cover 22 and the semi-cylindrical rib 27 of the second cover 25 support the operation shaft 42 of the plunger 40. With this configuration, the return coil spring 45 is compressed by pushing the trigger 70 closer to the housing 21, and the return coil spring 45 is expanded by releasing the trigger 70 to be separated from the housing 21, so that the plunger 40 reciprocates along the X axis in the contact/separation direction of the trigger 70. The assembling work is completed by integrating the first cover 22 with the second cover 25 by ultrasonic welding or by an adhesive.

Next, a method of operating the trigger switch 20 is described below.

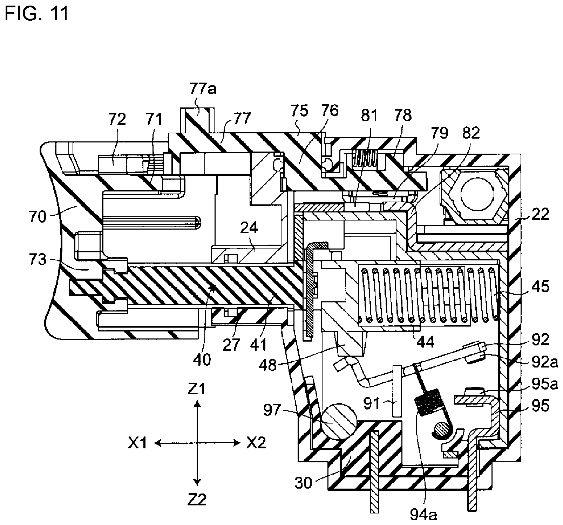

First, referring to FIG. 11, the plunger 40 is urged in the X1 direction by the urging force of the return coil spring 45 before operation. At this time, as shown in FIG. 8, the contact portions 51 of each of the sliders 50 attached to the plunger 40 are in contact with the first printed wiring board 60, but are not in contact with the sliding resistors 61. Further, as shown in FIG. 11, the opening/closing movable touch piece 92 is urged in the Z2 direction by the coil spring 94a. However, the position of the opening/closing movable touch piece 92 is restricted by the operation unit 48 of the plunger 40, and thus the movable contact 92a faces the fixed contact 95a at a distance from each other.

When an operator pushes the trigger 70 closer to the housing 21, the return coil spring 45 is compressed, and the plunger 40 slides in an axial direction of the operation shaft 42 (in the X2 direction). Therefore, the sliders 50 assembled to the plunger 40 slide on the first printed wiring board 60 and run on the sliding resistors 61. At this time, the sliders 50 and the sliding resistors 61 come into contact with each other with a maximum resistance value. At the same time, the restriction to the position of the opening/closing movable touch piece 92 by the operation unit 48 of the plunger 40 is released. Then, the opening/closing movable touch piece 92 rotates around the support of the movable contact terminal 91 by spring force of the coil spring 94a, and the opening/closing movable contact 92a of the opening/closing movable touch piece 92 comes in contact with the opening/closing fixed contact 95a of the fixed contact terminal 95.

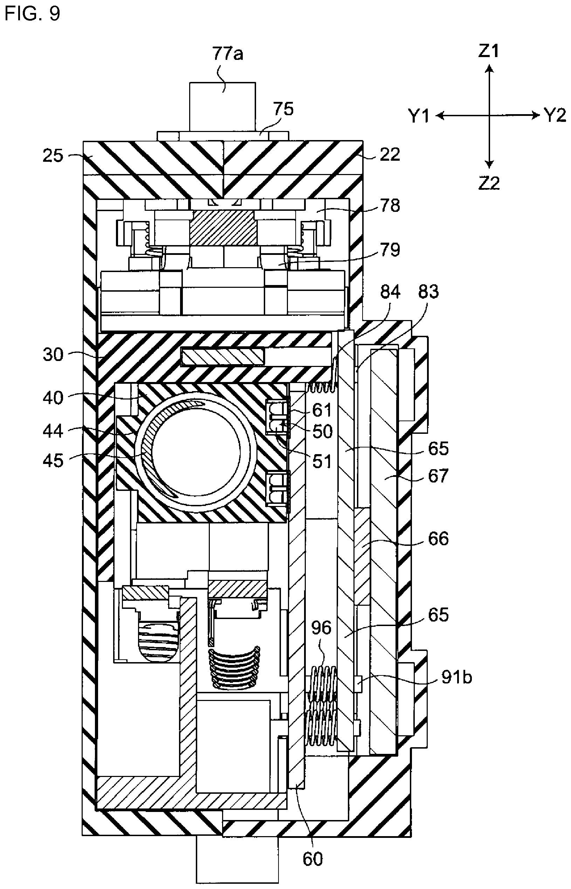

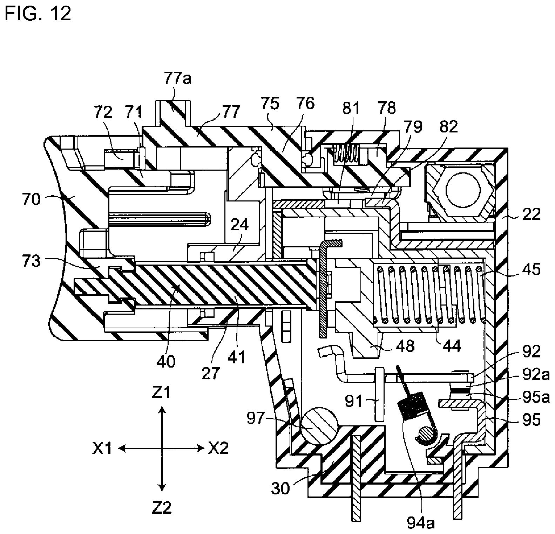

Further, when the trigger 70 is pushed closer to the housing 21, the plunger 40 is pushed in the X2 direction as shown in FIG. 12, and the sliders 50 slide on the sliding resistors 61. With this configuration, a resistance value decreases according to a pushing amount of the trigger 70. As shown in FIGS. 9 and 10, the resistance value is transmitted as a control signal from the first printed wiring board 60 to the power element 66 mounted on the second printed wiring board 65 through the first coil spring 84. With this configuration, the power element 66 adjusts the current supplied from the contact mechanism 90 according to the control signal and outputs the current to the motor.

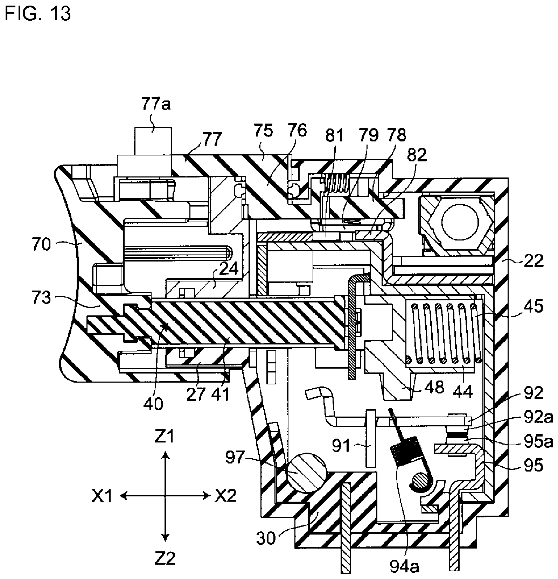

Further, when the trigger 70 is pushed closer to the housing 21, the plunger 40 is pushed into the rear side of the base 30 as shown in FIG. 13, and a sliding resistance value becomes nearly zero. As a result, the power element 66, which has received a change in the resistance value, outputs a control signal to maximize the rotation speed of the motor.

Next, when the operator releases the pushing of the trigger 70, the plunger 40 is pushed back away from the housing 21 by the spring force of the return coil spring 45, and the sliders 50 slide on the first printed wiring board 60 in a direction opposite to the above described direction (in the X1 direction). Then, the sliders 50 are detached from the sliding resistors 61 and returns to original positions on the first printed wiring board 60. As shown in FIG. 11, since the operation unit 48 of the plunger 40 rotates the opening/closing movable touch piece 92 in a direction opposite to the above described direction against the spring force of the coil spring 94a, the movable contact 92a is separated from the fixed contact 95a.

When the switching lever 75 is in a neutral position, one end of the switching lever 75 is in contact with the position regulating projection 72 of the trigger 70. This prevents pulling of the trigger 70, thus preventing erroneous operation.

In addition, according to the trigger switch 20, the first and second printed wiring boards 60, 65 are electrically connected to each other through the coil springs 84, 96 arranged between the first and second printed wiring boards 60, 65. In other words, both ends of the coil springs 84, 96 in the expansion/compression direction are respectively in contact with the first and second wiring patterns 62, 63 provided concentrically with the respective connection holes 64, 68 at the opening edge portions of the respective connection holes 64, 68 of the first and second printed wiring boards 60, 65, so that the opposing first and second printed wiring boards 60, 65 are electrically connected to each other. This makes it possible to prevents connection failure between the first printed wiring board and the second printed wiring board due to vibration or the like, thereby improving the contact reliability. Accordingly, contact failure between the first printed wiring board 60 and the second printed wiring board 65 due to vibration or the like can be reduced, and thus a trigger switch with high contact reliability can be provided.

Further, the heat of the power element of the second printed wiring board 65 is released to the outside of the housing 21 through the heat sink 67. This prevents degradation and destruction of the power element.

Further, according to the power driver 10, the trigger switch 20 makes it possible to achieve an electrical tool of which the control element 100 is less prone to deterioration and failure. In addition, the thickness of the wiring pattern can be adjusted for each printed wiring board as required, so that the sliders in sliding contact with the sliding resistors are made less prone to abrasion, thereby prolonging the life of the sliders and avoiding melting of the wiring pattern due to the flowing current.

### (Second Embodiment)

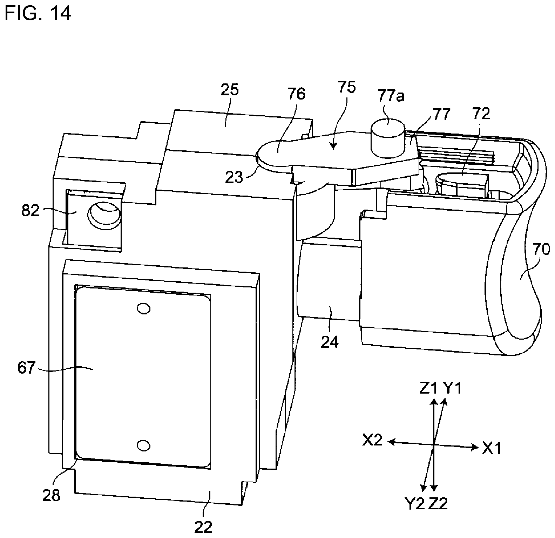

As shown in FIG. 14, a second embodiment is substantially the same as the above-described first embodiment. The difference is that a window portion 28 for exposing the heat sink 67 to the outside of the housing 21 is provided in the first cover 22 of the trigger switch 20. In other words, the heat sink 67 is exposed from the first cover 22 by fitting the heat sink 67 to the window portion 28. Thus, heat generated from the power element 66 can be efficiently dissipated to the outside of the housing 21, thereby achieving the trigger switch 20 that is further improved in heat dissipation performance.

Since the other components are the same as those of the first embodiment, the same components are denoted by the same reference numerals and the description thereof is omitted.

### (Third Embodiment)

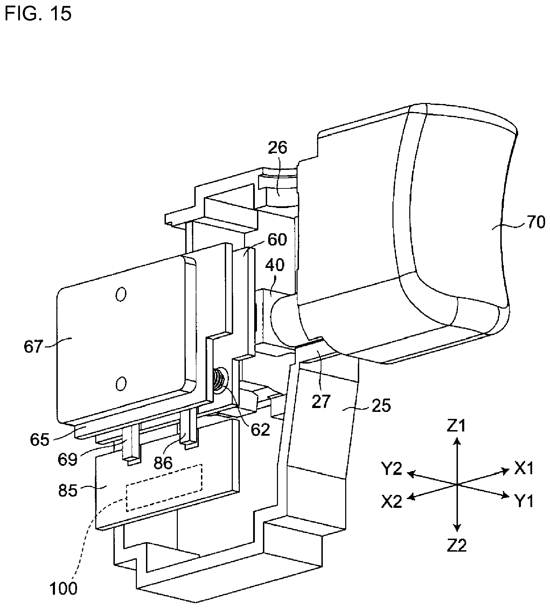

As shown in FIG. 15, a third embodiment is substantially the same as the above-described first embodiment. The difference is that three printed wiring boards are provided. Specifically, the first printed wiring board 60 is formed by a plurality of (two) printed wiring boards. The control element 100 with low heat resistance is mounted on a printed wiring board 85 that does not overlap with the second printed wiring board 65 in the thickness direction (in the Y1 and Y2 directions). A printed wiring board that does not overlap with the second printed wiring board 65 in the thickness direction and the printed wiring board 85 that does not face the second printed wiring board 65 are arranged such that the surfaces thereof extending in a direction orthogonal to the thickness direction (X-Z planes) are flush with each other, and are connected to each other through a connector 86 or the like.

In this manner, a control element having low heat resistance is mounted on the printed wiring board 85 that does not overlap with the second printed wiring board 65 in the thickness direction, and thus the control element having low heat resistance is hardly affected by the heat generated from the power element 66. As a result, a trigger switch 20 of which the control element is less prone to deterioration and failure can be achieved.

It is essential that the printed wiring board be divided into at least two boards. It is essential that the printed wiring boards are configured such that heat generated by the power element mounted on one of the printed wiring boards does not adversely affect the control element mounted on the other printed wiring board.

### (Other Embodiments)

The trigger switch 20 according to the embodiments of the present invention has been concretely described from the first embodiment to the third embodiment. The present invention is not limited to the above-described embodiments, and various modifications can be made without departing from the scope of the invention. For example, the present invention can be modified as described below, and such modifications are also within the technical scope of the present invention.

It is essential that the first printed wiring board 60 and the second printed wiring board 65 are electrically connected to each other at least at one place, although the first printed wiring board 60 and the second printed wiring board 65 according to the first embodiment are electrically connected to each other at a plurality of places through the first and the second shaft portions 83, 91b respectively extending from the first relay terminal 81 and the movable contact terminal 91, and the first and the second coil springs 84, 96. The printed wiring boards may be fixed to each other by any known electrical connection method, instead of the shaft portions of the relay terminals.

An arrangement of the printed wiring boards can be flexibly changed, and may be changed as appropriate according to an arrangement or a sliding direction of the sliders 50 that are assembled to the plunger 40. Therefore, the first printed wiring board 60 and the second printed wiring board 65 do not necessarily face each other. For example, the first printed wiring board 60 and the second printed wiring board 65 may be arranged so as to form a predetermined angle.

According to the first embodiment, a predetermined space (gap) is provided between the first printed wiring board 60 and the second printed wiring board 65. However, any structure may be used as long as the heat generated by the power element 66 of the second printed wiring board 65 is hardly transmitted to the control element of the first printed wiring board 60. For this reason, as shown in FIG. 6, a known heat insulating sheet 110 (an example of a heat insulating member) may be provided between the first printed wiring board 60 and the second printed wiring board 65, for example. With this configuration, the control element mounted on the first printed wiring board is hardly affected by the heat of the power element mounted on the second printed wiring board, thereby preventing deterioration or destruction of the control element.

Further, a known heat dissipation member can be used as long as the heat sink 67 of the first embodiment has a heat radiating function. A heat transfer sheet or the like for facilitating the transfer of heat may be provided between the heat sink 67 and the power element. Further, the method of fixing the heat dissipation member with the second printed wiring board 65 is not limited to the fixing with metal fittings such as rivets, but other known fixing methods may also be used.

Various embodiments of the present invention have been described in detail with reference to the drawings, and finally, various aspects of the present invention are described below.

A trigger switch according to a first aspect of the present invention includes:
a plunger having an operation shaft and moving in an axial direction of the operation shaft;
a slider that has conductivity and is provided on the plunger along the axial direction of the operation shaft;
a first printed wiring board having a sliding resistor with which the slider is in sliding contact; and
a second printed wiring board electrically connected to the first printed wiring board,
wherein the first printed wiring board includes a control element that forms a control circuit together with the sliding resistor, and
wherein the second printed wiring board includes a power element configured to supply electric current based on a control signal of the control element.

In other words, the trigger switch according to the first aspect includes:
a housing;
a trigger provided outside the housing;
a plunger that connects the trigger to the housing so as to approach or separate from the housing, and includes a slider disposed inside the housing;
a first printed wiring board that is disposed inside the housing and includes a sliding resistor configured to contact the slider and a control element that configures a control circuit together with the sliding resistor; and
a second printed wiring board that is disposed inside the housing separately from the first printed wiring board and electrically connected to the first printed wiring board, and includes a power element configured to supply electric current based on a signal of the control element.

According to the trigger switch of the first aspect, the control element constituting the control circuit and the power element for supplying electric current to the electrical tool or the like are respectively provided on the separate printed wiring boards, and thus the control element is hardly affected by heat generated by the power element. As a result, a trigger switch of which a control element is less prone to deterioration and failure can be achieved.

Further, the thickness of the wiring pattern can be adjusted for each printed wiring board as required. For example, reducing the thickness of the sliding resistors of the first printed wiring board leads to reduction in abrasion of the sliders that are in sliding contact with the sliding resistors, thereby increasing the life of the trigger switch.

Further, for example, increasing the thickness of the wiring pattern of the second printed wiring board can prevent melting of the wiring pattern due to the flowing current, thereby achieving a safe trigger switch.

In the trigger switch according to a second aspect of the present invention,
the first printed wiring board and the second printed wiring board are arranged to face each other with a predetermined gap therebetween, and
the first printed wiring board and the second printed wiring board may be electrically connected to each other through a coil spring disposed between the first printed wiring board and the second printed wiring board.

In other words, in the trigger switch of the second aspect,
the first printed wiring board and the second printed wiring board are arranged to face each other with a predetermined gap therebetween in a thickness direction,
the trigger switch further includes:
a coil spring disposed between the first printed wiring board and the second printed wiring board, both ends of the coil spring in an expansion/compression direction being in contact with the first printed wiring board and the second printed wiring board, and
the coil spring electrically connecting the first printed wiring board to the second printed wiring board.

According to the trigger switch of the second aspect, the first printed wiring board and the second printed wiring board are electrically connected to each other through the coil spring disposed between the first printed wiring board and the second printed wiring board . As a result, contact failure between the first printed wiring board and the second printed wiring board due to vibration or the like can be reduced, so that a trigger switch with high contact reliability can be achieved.

In the trigger switch according to a third aspect of the present invention,
the first printed wiring board may have a first connection hole,
the first printed wiring board may have a first wiring pattern on a surface thereof facing the second printed wiring board, the first wiring pattern being provided concentrically with the first connection hole at an opening edge portion of the first connection hole,
the second printed wiring board may have a second connection hole,
the second printed wiring board may have a second wiring pattern on a surface thereof facing the first printed wiring board, the second wiring pattern being provided concentrically with the second connection hole at an opening edge portion of the second connection hole,
both ends of the coil spring may be in contact with the first wiring pattern and the second wiring pattern, and
a conductive metal fitting may be inserted in each of the first connection hole and the second connection hole.

In other words, in the trigger switch of the third aspect,
the first printed wiring board includes:
the first connection hole penetrating the first printed wiring board in a thickness direction; and
the first wiring pattern at the opening edge portion of the first connection hole on the surface of the first printed wiring board that faces the second printed wiring board, the first wiring pattern being provided concentrically with the first connection hole,
the second printed wiring board includes:
the second connection hole penetrating the second printed wiring board in a thickness direction; and
the second wiring pattern at the opening edge portion of the second connection hole on the surface of the second printed wiring board that faces the first printed wiring board, the second wiring pattern being provided concentrically with the second connection hole, and
both ends of the coil spring in the expansion/compression direction are in contact with the first printed wiring board and the second printed wiring board, and
the trigger switch further including the conductive metal fitting that extends through an inside of the coil spring and is connected to the first wiring pattern of the first connection hole and the second wiring pattern of the second connection hole.

According to the trigger switch of the third aspect, both ends of the coil spring in the expansion/compression direction are in contact with the wiring patterns provided concentrically with the connection holes at the opening edge portions of the connection holes of the respective printed wiring boards, so that the opposed first and second printed wiring boards are electrically connected to each other. This makes it possible to prevents connection failure between the first printed wiring board and the second printed wiring board due to vibration or the like, thereby improving the contact reliability.

In addition, the conductive metal fitting is inserted in each of the first connection hole and the second connection hole, thereby providing a power circuit having a path different from that of a signal circuit formed by the coil spring. With this configuration, a center hole of the coil spring is effectively utilized, and thus a space-saving trigger switch can be obtained.

In the trigger switch according to a fourth aspect of the present invention,
the power element may be provided on an outwardly facing surface of the second printed wiring board and may be sandwiched between the second printed wiring board and a heat dissipation member.

In other words, the trigger switch of the fourth aspect further includes:
the heat dissipation member having a plate shape that is provided inside the housing and is arranged in parallel with the first printed wiring board and the second printed wiring board,
the second printed wiring board is disposed between the first printed wiring board and the heat dissipation member, and
the power element is provided on a surface of the second printed wiring board that faces the heat dissipation member.

According to the trigger switch of the fourth aspect, the heat of the power element is released to the outside of the housing through the heat dissipation member. This prevents degradation and destruction of the power element.

The trigger switch according to a fifth aspect of the present invention may include:
a window portion configured to fit the heat dissipation member on a side surface of the housing that houses the first printed wiring board and the second printed wiring board, and
the heat dissipation member may be exposed to the outside from the window portion.

In other words, in the trigger switch of the fifth aspect,
the housing includes the window portion that allows the heat dissipation member to be exposed outside the housing.

According to the trigger switch of the fifth aspect, the heat of the power element is released to the outside of the housing through the heat dissipation member and the window portion. Therefore, degradation and destruction of the power element can be reliably prevented.

In the trigger switch according to a sixth aspect of the present invention,
a heat insulating member may be disposed between the first printed wiring board and the second printed wiring board.

In other words, the trigger switch of the sixth aspect further includes:
the heat insulating member disposed between the first printed wiring board and the second printed wiring board.

According to the trigger switch of the sixth aspect, the control element mounted on the first printed wiring board is hardly affected by the heat generated by the power element mounted on the second printed wiring board by disposing the heat insulating member. Therefore, deterioration or destruction of the control element can be prevented.

In the trigger switch according to a seventh aspect of the present invention,
a third printed wiring board on which the control element is mounted may be arranged so as to be flush with the first printed wiring board.

In other words, the trigger switch of the seventh aspect,
the first printed wiring board includes a plurality of printed wiring boards that are arranged such that surfaces of the plurality of printed wiring boards that extends in a direction orthogonal to the thickness direction of the first printed wiring board are flush with each other.

According to the trigger switch of the seventh aspect, for example, the first printed wiring board is constituted by a printed wiring board opposed to the second printed wiring board and a printed wiring board not opposed to the second printed wiring board, and the control element is mounted on the printed wiring board not opposed to the second printed wiring board 65, thereby reducing influence on the control element due to heat generated by the power element provided on the second printed wiring board. Therefore, deterioration or destruction of the control element can be prevented.

In order to solve the above problem, an electrical tool of an eighth aspect of the present invention includes the above described trigger switch.

According to the electrical tool of the eighth aspect, the control element constituting the control circuit and the power element for supplying the current to the electrical tool or the like are respectively provided on separate printed wiring boards. With this configuration, the control element to form the control circuit is less likely to be adversely affected by heat generation by the power element. As a result, an electrical tool of which a control element is less prone to deterioration and failure can be achieved.

Further, the thickness of the wiring pattern can be adjusted for each printed wiring board as required. For example, the sliding resistors of the first printed wiring board are made thin, so that abrasion of the sliders that are in sliding contact with the sliding resistors is reduced and the life of the trigger switch is increased.

Furthermore, for example, the wiring pattern of the second printed wiring board is made thick, so that melting of the wiring pattern due to the flowing current can be avoided, thereby achieving a safe electrical tool.

Note that the advantage of each embodiment or modification can be achieved by properly combining arbitrary embodiments or modifications of the above-described various embodiments and modifications. Additionally, it is possible to combine embodiments, combine examples, or combine an embodiment(s) and an example(s), and also possible to combine features of different embodiments or different examples.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless departing therefrom.

### INDUSTRIAL APPLICABILITY

The trigger switch according to the present invention can be applied not only to the above-mentioned trigger switch but also to other switches. In addition, the trigger switch according to the present invention can be applied not only to a power driver, but also to other electrical tools such as an impact driver, an electric chain saw, and a vacuum cleaner.

Further, the electrical tool according to the present invention can be used, for example, for construction work or for cleaning at home.

### DESCRIPTION OF SYMBOLS

- 10: power driver (an example of electrical tools)
- 11: power driver body
- 111: drive mechanism housing
- 12: grip
- 13: connection base
- 14: anvil
- 20: trigger switch
- 21: housing
- 22: first cover
- 23: fitting recess
- 24: semi-cylindrical rib
- 25: second cover
- 26: fitting recess
- 27: semi-cylindrical rib
- 28: window portion
- 30: base
- 31: opening
- 32: notch
- 40: plunger
- 41: operation table
- 42: operation shaft
- 43: engagement rib
- 44: fitting hole
- 45: return coil spring
- 46: press-fitting groove
- 47: press-fitting notch
- 48: operation unit
- 50: slider
- 51: contact portion
- 52: elastic claw portion
- 60: first printed wiring board
- 61: sliding resistor
- 62: first wiring pattern
- 63: second wiring pattern
- 64: first connection hole
- 65: second printed wiring board
- 66: power element
- 67: heat sink (an example of heat dissipation members)
- 68: fourth connection hole
- 70: trigger
- 71: reinforcing rib
- 72: position regulating projection
- 73: engagement receiving portion
- 75: switching lever
- 76: rotation shaft
- 77: operation unit
- 77a: operation projection
- 78: switching unit
- 79: rotating contact piece
- 80: forward/reverse switching mechanism
- 81: first relay terminal
- 82: external terminal
- 83: first shaft portion (an example of conductive metal fittings)
- 84: first coil spring
- 85: printed wiring board
- 86: connector
- 90: contact mechanism
- 91: movable contact terminal
- 91b: second shaft portion (an example of conductive metal fittings)
- 92: opening/closing movable touch piece
- 92a: opening/closing movable contact
- 94a: coil spring
- 95: fixed contact terminal
- 95a: opening/closing fixed contact
- 95b: third shaft portion (an example of conductive metal fittings)
- 96: second coil spring
- 97: diode
- 100: control element
- 110: insulating sheet (an example of heat insulating members)

## Claims

1. A trigger switch comprising:
a housing;
a trigger provided outside the housing;
a plunger that connects the trigger to the housing so as to approach or separate from the housing, and includes a slider disposed inside the housing;
a first printed wiring board that is disposed inside the housing and includes a sliding resistor configured to contact the slider and a control element that configures a control circuit together with the sliding resistor; and
a second printed wiring board that is disposed inside the housing separately from the first printed wiring board and electrically connected to the first printed wiring board, and includes a power element configured to supply electric current based on a signal of the control element.

2. The trigger switch according to claim 1,
wherein the first printed wiring board and the second printed wiring board are arranged to face each other with a predetermined gap therebetween in a thickness direction,
the trigger switch further comprising:
a coil spring disposed between the first printed wiring board and the second printed wiring board, both ends of the coil spring in an expansion/compression direction being in contact with the first printed wiring board and the second printed wiring board,
the coil spring electrically connecting the first printed wiring board to the second printed wiring board.

3. The trigger switch according to claim 2,
wherein the first printed wiring board includes:
a first connection hole penetrating the first printed wiring board in the thickness direction; and
a first wiring pattern at an opening edge portion of the first connection hole on a surface of the first printed wiring board that faces the second printed wiring board, the first wiring pattern being provided concentrically with the first connection hole,
wherein the second printed wiring board includes:
a second connection hole penetrating the second printed wiring board in the thickness direction; and
a second wiring pattern at an opening edge portion of the second connection hole on a surface of the second printed wiring board that faces the first printed wiring board, the second wiring pattern being provided concentrically with the second connection hole, and
wherein the both ends of the coil spring in the expansion/compression direction are in contact with the first printed wiring board and the second printed wiring board,
the trigger switch further comprising a conductive metal fitting that extends through an inside of the coil spring and is connected to the first wiring pattern of the first connection hole and the second wiring pattern of the second connection hole.

4. The trigger switch according to any one of claims 1 to 3, further comprising:
a heat dissipation member having a plate shape that is provided inside the housing and is arranged in parallel with the first printed wiring board and the second printed wiring board,
wherein the second printed wiring board is disposed between the first printed wiring board and the heat dissipation member, and
wherein the power element is provided on a surface of the second printed wiring board that faces the heat dissipation member.

5. The trigger switch according to any one of claims 1 to 4, wherein the housing includes a window portion that allows the heat dissipation member to be exposed outside the housing.

6. The trigger switch according to any one of claims 1 to 5, further comprising a heat insulating member disposed between the first printed wiring board and the second printed wiring board.

7. The trigger switch according to any one of claims 1 to 6, wherein the first printed wiring board comprises a plurality of printed wiring boards that are arranged such that surfaces of the plurality of printed wiring boards that extends in a direction orthogonal to the thickness direction of the first printed wiring board are flush with each other.

8. An electrical tool comprising the trigger switch according to any one of claims 1 to 7.
